# EUROPÄISCHE PATENTANMELDUNG

(11) **EP 1 119 052 A2**
(43) Veröffentlichungstag der Anmeldung: **25.07.2001**
(21) Anmeldenummer: 01100975.0
(22) Anmeldetag: 17.01.2001
(51) Int. Cl.: H01L 29/78, H01L 29/08, H01L 29/36

(54) **Vertikale DMOS-Transistoranordnung mit niedrigem Einschaltwiderstand**

(30) Priorität: 19.01.2000 DE 10002129
(71) Anmelder: Infineon Technologies AG, 81669 München (DE)
(72) Erfinder: Heiss, Heinrich, 81373 München (DE); Krischke, Norbert, 80638 München (DE)
(74) Vertreter: MÜLLER & HOFFMANN Patentanwälte

(57) **Zusammenfassung**

Die Erfindung betrifft eine vertikale DMOS-Transistoranordnung, bei der zur Reduzierung des Einschaltwiderstandes Ron im Bereich des Drain-Source-Strompfades (IDS) im Buried Layer (2) eine Zusatzimplantation (9) vorgesehen ist.

## Beschreibung

Die vorliegende Erfindung betrifft eine vertikale DMOS-Transistoranordnung mit einer in einen Oberflächenbereich eines Halbleiterbereiches des einen Leitungstyps eingebrachte Sourcezone des einen Leitungstyps, einer die Sourcezone umgebenden und diese von dem Halbleiterbereich trennenden Bodyzone des anderen, zum einen Leitungstyp entgegengesetzten Leitungstyps, einer die Bodyzone im Abstand überlagernden Gateelektrode und einem den Halbleiterbereich unterlagernden Buried Layer des einen Leitungstyps, der höher dotiert ist als der Halbleiterbereich.

Bei der Entwicklung von Leistungstransistoren ist es ein wichtiges Ziel, für diese einen niedrigen Einschaltwiderstand Ron auf einer möglichst kleinen Chipfläche A bei gleichzeitig hoher Drain-Source-Durchbruchspannung BDV, also großer Spannungsfestigkeit, zu erzielen. Ein unipolarer Leistungstransistor, der sich durch sehr kleine Werte des Produktes aus dem Einschaltwiderstand Ron und der Chipfläche A auszeichnet, ist der DMOS-Transistor (DMOS = Double Diffused MOS). Bei einem solchen DMOS-Leistungstransistor ist die Driftzone zwischen Gate und Drain in vertikaler Richtung, also senkrecht zur Oberfläche des Silizium-Halbleiterkörpers des Leistungstransistors ausgeführt. Die Länge der Driftzone, also des Halbleiterbereiches des einen Leitungstyps, die über die Dicke einer auf ein Silizium-Halbleitersubstrat aufgewachsenen epitaktischen Schicht eingestellt wird, sowie die Dotierungskonzentration in der Driftzone definieren das Produkt aus dem Einschaltwiderstand Ron und der Chipfläche A sowie die Drain-Source-Durchbruchspannung BDV, also die Spannungsfestigkeit des DMOS-Transistors.

Um nun bei vertikalen DMOS-Leistungstransistoren möglichst niedrige Werte des Produktes aus dem Einschaltwiderstand Ron und der Chipfläche A zu erreichen, wird unter anderem der bereits erwähnte Buried Layer durch Implantation vor Auftragen der epitaktischen Siliziumschicht in das Siliziumsubstrat eingebracht.

Ein solcher Buried Layer (BL) ist aus der Planartechnik wohlbekannt und wird neben einer Vielzahl von anderen Bauelementen auch in den sogenannten SMART-POWER TECHNOLOGIEN (SPT) eingesetzt. Bei Anwendung eines Buried Layers müssen sowohl dessen Dotierungsdosis als auch seine Ausdiffusionsweite für alle betroffenen Bauelemente gleichsam optimiert werden. Dies bedeutet für einen DMOS-Transistor, daß der Buried Layer dessen Anforderungen hinsichtlich eines niedrigen Einschaltwiderstandes und einer hohen Drain-Source-Durchbruchspannung genügen muß.

Insgesamt lassen sich somit die Anforderungen, denen ein Buried Layer bei einer DMOS-Transistoranordnung nachkommen muß, wie folgt kurz zusammenfassen:
- Es muß ein niederohmiger Anschluß des Kollektors (KT) gewährleistet sein, der von oben zum Buried Layer hin eindiffundiert wird, um den Einschaltwiderstand im Anschlußgebiet zwischen dem Kollektor und dem Buried Layer zu reduzieren.
- Der Einschaltwiderstand Ron des DMOS-Transistors unterhalb des Zellenfeldes muß reduziert sein.
- Der Buried Layer muß einen Schutz vor parasitären Bipolartransistoren durch Reduzierung von deren Stromverstärkung β gewährleisten.

Gegenwärtig wird ganzflächig unter vielen Bauelementen in SPT-Technologie ein Buried Layer implantiert und ausdiffundiert, wobei ein Kompromiß zwischen Dicke der epitaktischen Schicht dieser Bauelemente, der Dotierungsdosis des Buried Layers und der vertikalen Ausdiffusionsweite des Buried Layers eingegangen wird, damit eine akzeptable Durchbruchspannung der Bauelemente eingestellt und gleichzeitig ein kleiner Einschaltwiderstand Ron erreicht werden kann. Dabei ist bekannt, daß eine hohe Dotierungsdosis des Buried Layers bzw. eine große Basisweite die Stromverstärkung β von parasitären vertikalen pnp-Transistoren reduziert.

Speziell bei DMOS-Transistoren wird die vertikale Drain-Source-Durchbruchspannung zwischen p-leitender Basiszone bzw. p⁺-leitender Bodyzone (BV) und Buried Layer über die Dicke der dazwischenliegenden, niedrig dotierten n-leitenden epitaktischen Schicht eingestellt. Die Durchbruchstrecke (BDV) liegt dabei aber nicht im Strompfad (IDS) des Leitungstransistors, wie dies noch weiter unten näher erläutert werden wird. Da aber die am Prozeßende übriggebliebene, niedrig dotierte epitaktische Schicht in der Durchbruchstrecke kleiner ist als die Strecke, die der Drainstrom durchfließt, läßt sich bei den üblichen DMOS-Leistungstransistoren ein höherer Einschaltwiderstand Ron nicht vermeiden.

Es ist somit Aufgabe der vorliegenden Erfindung, eine vertikale DMOS-Transistoranordnung zu schaffen, die sich bei hoher Durchbruchspannung durch einen niedrigen Einschaltwiderstand Ron auszeichnet.

Diese Aufgabe wird bei einer vertikalen DMOS-Transistoranordnung der eingangs genannten Art erfindungsgemäß dadurch gelöst, daß im Bereich des Drain-Source-Strompfades unterhalb von der Gateelektrode in den Buried Layer eine den Einschaltwiderstand reduzierende Zusatzdotierung des einen Leitungstyps eingebracht ist.

Bei dieser Zusatzdotierung handelt es sich in bevorzugter Weise um eine Zusatzimplantation, die in solchen Gebieten des Buried Layers vorgesehen ist, welche im Bereich des Drain-Source-Strompfades liegen. Eine Zusatzimplantation kann auf einfache Weise mittels lediglich einer weiteren Maske realisiert werden. An solchen Stellen des Buried Layers, an denen eine geringe Ausdiffusion nach oben notwendig ist, damit die Durchbruchspannung zwischen Basis und Buried Layer nicht in unzulässiger Weise vermindert wird, kann die Zusatzimplantation beispielsweise über Photolack maskiert werden. Dagegen wird in bevorzugter Weise im Bereich der DMOS-Polystege, die im Bereich der Drain-Source-Strompfade liegen, die Zusatzimplantation eingebracht.

Für die Zusatzdotierung kann ein Dotierstoff gewählt werden, der im Vergleich zur Dotierung des Buried Layers eine größere Diffusionskonstante besitzt, da der Dotierstoff für die Zusatzdotierung bei gleichem Temperaturbudget über den Buried Layer hinaus ausdiffundieren muß. Ist der Buried Layer beispielsweise mit Antimon dotiert, so kann für die Zusatzdotierung Phosphor oder Arsen eingesetzt werden.

Nachfolgend wird die Erfindung anhand der Zeichnungen näher erläutert. Es zeigen:
- Fig. 1: einen Schnitt durch eine vertikale DMOS-Transistoranordnung mit einer Zusatzimplantation unter dem Gate als ein erstes Ausführungsbeispiel der Erfindung,
- Fig. 2 und 3: verschiedene Gestaltungen der Zusatzimplantation und
- Fig. 4: einen Anschluß eines Buried Layers über einen weniger tief eingetriebenen Kollektor und eine Zusatzimplantation als ein weiteres Ausführungsbeispiel der Erfindung.

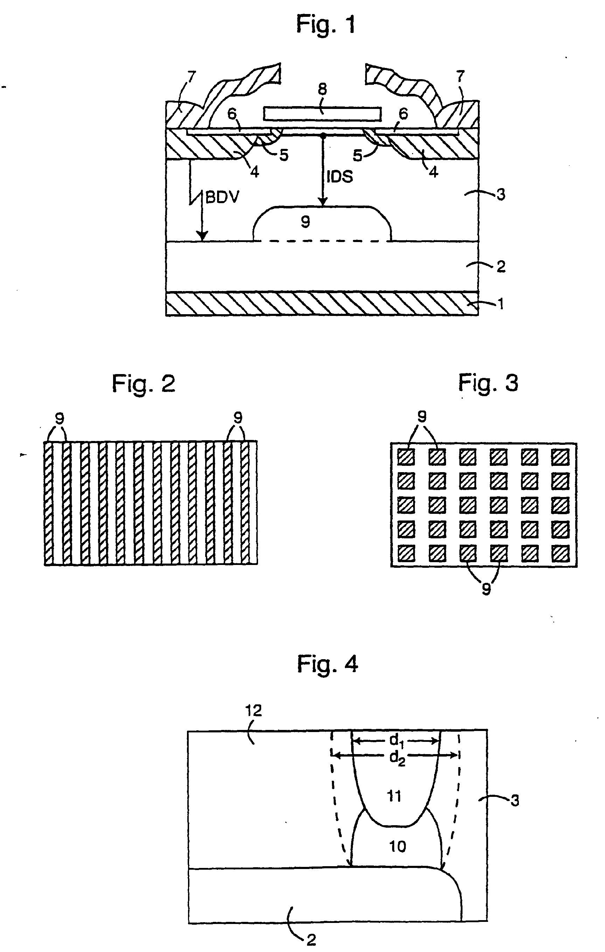

Fig. 1 zeigt eine DMOS-Zelle mit einem p-leitenden Siliziumsubstrat 1, auf dem ein n-leitender Buried Layer 2 vorgesehen ist, der beispielsweise mit Antimon dotiert ist. Auf dem Buried Layer 2 ist eine n-leitende epitaktische Schicht vorgesehen, welche einen Halbleiterbereich 3 bildet. In diesen Halbleiterbereich 3 ist eine p⁺-leitende Bodyzone 4 mit einer p-leitenden Basis 5 eingebracht. In der Bodyzone 4 bzw. der Basis 5 befindet sich noch eine n⁺-leitende Sourcezone 6. Die Sourcezone 6 und die Bodyzone 4 sind mit einer Sourcemetallisierung 7 versehen, während die Bodyzone 4 bzw. die Basis 5 im Abstand von einer Gateelektrode 8 überlagert ist, die in eine in der Fig. 1 nicht gezeigte Isolierschicht eingebettet ist. Für die Gateelektrode 8 kann beispielsweise polykristallines Silizium verwendet werden, während Siliziumdioxid für die Isolierschicht herangezogen wird.

Erfindungsgemäß ist eine Zusatzdotierung 9 der gleichen Polarität wie der Buried Layer 2 im Bereich des Drain-Source-Strompfades IDS unterhalb von der Gateelektrode 8 vorgesehen. Diese Zusatzdotierung 9 kann durch Implantation von beispielsweise Phosphor oder Arsen, also einem Dotierstoff mit größerer Diffusionskonstante als der Dotierstoff des Buried Layers, auf einfache Weise mittels nur einer Zusatzmaske erzeugt werden. An Stellen, an denen eine geringe Ausdiffusion des Buried Layers 2 nach oben notwendig ist, also beispielsweise unterhalb der Bodyzone 4, damit hier die Durchbruchstrecke BDV nicht vermindert wird, kann die Zusatzdotierung mittels Photolack maskiert werden. Dieser Photolack wird aufgetragen, bevor die epitaktische Schicht zur Bildung des Halbleiterbereiches 3 auf den implantierten und mit der Zusatzdotierung versehenen Buried Layer abgeschieden wird.

Durch die Zusatzdotierung 9 aus beispielsweise Phosphor oder Arsen und die damit erzielte höhere Dotierung und größere Ladungsträgerdichte im Drain-Source-Strompfad IDS verringert sich der Einschaltwiderstand Ron ohne gleichzeitige Herabsetzung der Durchbruchspannung zwischen Drain und Source im Halbleiterbereich zwischen der Bodyzone 4 und dem Buried Layer 2 (vgl. den Pfeil BDV).

Wesentlich an der erfindungsgemäßen vertikalen DMOS-Transistoranordnung ist, daß die Zusatzdotierung 9 nicht ganzflächig unter dem DMOS-Zellenfeld eingebracht wird, da sich sonst die Source-Drain-Durchbruchspannung in vertikaler Richtung zwischen der Bodyzone 4 und dem Buried Layer 2 bzw. der ganzflächigen Zusatzdotierung 9 verringern würde. Aus diesem Grund ist die Zusatzdotierung 9 allein auf den Bereich unterhalb des Gates, also der polykristallinen Siliziumstege, auf die Ausdehnung des Drain-Source-Strompfades IDS zu begrenzen. Mit anderen Worten, die Zusatzdotierung wird nur unterhalb des Gates in den Drain-Source-Strompfad IDS eingebracht.

Die Zusatzdotierung 9 wirkt sich bevorzugt erst bei größeren Drain-Source-Durchbruchspannungen UDS über 60 V deutlich auf den Einschaltwiderstand Ron der DMOS-Transistoranordnung aus, da bei hohen Durchbruchspannungen der Einschaltwiderstand Ron hauptsächlich von der Dicke der niedrig dotierten epitaktischen Schicht des Halbleitergebietes 3 und nicht mehr von Kontaktwiderständen der Source-Metallisierung 7 dominiert wird. Versuche haben gezeigt, daß durch die erfindungsgemäße Zusatzdotierung 9 das Produkt aus dem Einschaltwiderstand Ron und der Fläche A von etwa 0,67 Ωmm_ auf 0,56 Ωmm_, also um etwa 16,5 %, reduziert werden kann, während eine Verminderung der Durchbruchspannung BDV zwischen der Bodyzone 4 bzw. der Basis 5 und dem Buried Layer 2 nur um etwa 4,0 V, was 2,5 % entspricht, eintritt.

Die Zusatzdotierung 9 kann in der Form eines Streifen-Designs, wie dies in Fig. 2 gezeigt ist, oder als Schachbrettmuster, wie dies in Fig. 3 dargestellt ist, ausgeführt werden, wobei sie sich immer unter den polykristallinen Siliziumstegen befindet, welche die Gateelektroden 8 bilden. Es entstehen so Dotierstreifen (vgl. Fig. 2) bzw. Dotiersäulen (vgl. Fig. 3) lediglich im Bereich des Drain-Source-Strompfades IDS der DMOS-Transistoranordnung. Diese Dotierstreifen bzw. Dotiersäulen können in äußerst einfacher Weise mittels lediglich einer zusätzlichen Maske durch Implantation erzeugt werden, indem in den Buried Layer im Bereich des Drain-Strom-Pfades die Zusatzimplantation über Lack eingebracht wird.

Der Buried Layer ist bekanntlich mit einem in Fig. 1 nicht gezeigten Kollektoranschluß verbunden, der für eine niederohmige Verbindung zwischen Buried Layer und der Oberfläche des Halbleiterkörpers sorgt. Dieser Kollektoranschluß wird bisher durch eine Kollektortiefdiffusion (uKT) erzeugt.

Bei der erfindungsgemäßen vertikalen DMOS-Transistoranordnung wird der Buried Layer unterhalb des Kollektoranschlusses mit einer weiteren Zusatzdotierung, insbesondere Zusatzimplantation, versehen. Diese diffundiert nach oben weiter aus als der Buried Layer, so daß dann die Kollektortiefdiffusion nicht mehr so tief angetrieben zu werden braucht, um für einen niedrigen Anschlußwiderstand zum Buried Layer zu sorgen. Die geringe Eindringtiefe der Kollektortiefdiffusion führt auch zu einer verringerten lateralen Ausdiffusion des Kollektors und damit zu einer Flächeneinsparung bei Bauelementen mit Kollektoranschluß an den Buried Layer.

Fig. 4 zeigt hierfür ein Ausführungsbeispiel mit dem Buried Layer 2, einer Zusatzimplantation 10 und einer Kollektortiefdiffusion 11. Die Zusatzimplantation 10 und die Kollektortiefdiffusion 11 sind beide n-leitend. Wird die Kollektortiefdiffusion 11 nur von der Oberseite 12 aus eingebracht, so führt dies zu einer größeren lateralen Ausdehnung d₂, während unter Berücksichtigung der Zusatzimplantation 10 die laterale Ausdehnung der Kollektortiefdiffusion 11 einen kleineren Wert d₁ annehmen kann.

### Bezugszeichenliste

- 1: Siliziumsubstrat
- 2: Buried Layer
- 3: Halbleiterbereich
- 4: Bodyzone
- 5: Basis
- 6: Sourcezone
- 7: Sourcemetallisierung
- 8: Gateelektrode
- 9: Zusatzdotierung
- 10: Zusatzdotierung
- 11: Kollektortiefdiffusion
- 12: Oberfläche
- IDS: Drain-Source-Strom
- BDV: Durchbruchspannung

## Patentansprüche

1. Vertikale DMOS-Transistoranordnung mit einer in einen Oberflächenbereich eines Halbleiterbereiches (3) des einen Leitungstyps eingebrachten Sourcezone (6) des einen Leitungs-typs, einer die Sourcezone (6) umgebenden und diese von dem Halbleiterbereich (3) trennenden Bodyzone (4, 5) des anderen, zum einen Leitungstyp entgegengesetzten Leitungstyps, einer die Bodyzone (4, 5) im Abstand überlagernden Gateelektrode (8), einem den Halbleiterbereich (3) unterlagernden Buried Layer (2) des einen Leitungstyps, der höher dotiert ist als der Halbleiterbereich (3), und einer im Bereich des Drain-Source-Strompfades (IDS) in den Buried Layer (2) eingebrachten und den Einschaltwiderstand (Ron) reduzierenden Zusatzdotierung (9) des einen Leitungstyps,
**dadurch gekennzeichnet**, daß
die Zusatzdotierung (9) allein auf den Bereich des Buried Layers (2) unterhalb von der Gateelektrode (8) begrenzt ist.

2. Vertikale DMOS-Transistoranordnung nach Anspruch 1,
**dadurch gekennzeichnet**, daß die Zusatzdotierung (9) eine Zusatzimplantation ist.

3. Vertikale DMOS-Transistoranordnung nach Anspruch 1 oder 2,
**dadurch gekennzeichnet**, daß die Zusatzdotierung einen Dotierstoff mit größerer Diffusionskonstante als der Dotierstoff des Buried Layers (2) aufweist.

4. Vertikale DMOS-Transistoranordnung nach Anspruch 3,
**dadurch gekennzeichnet**, daß der Dotierstoff der Zusatzdotierung (9) Phosphor oder Arsen ist, wenn der Buried Layer als Dotierstoff Antimon aufweist.

5. Vertikale DMOS-Transistoranordnung nach einem der Ansprüche 1 bis 4,
**dadurch gekennzeichnet**, daß die Zusatzdotierung (9) streifenförmig oder schachbrettartig strukturiert ist.

6. Vertikale DMOS-Transistoranordnung nach einem der Ansprüche 1 bis 5,
**dadurch gekennzeichnet**, daß eine weitere Zusatzdotierung (10) im Buried Layer (2) unterhalb einer Kollektortiefdiffusion (11) vorgesehen ist.

7. Vertikale DMOS-Transistoranordnung nach einem der Ansprüche 1 bis 6,
**dadurch gekennzeichnet**, daß die Zusatzdotierung (9) über Photolack maskiert ist.
